# EUROPEAN PATENT SPECIFICATION

(11) **EP 4 619 838 B1**
(45) Date of publication and mention of the grant of the patent: **12.08.2026**
(21) Application number: 23777145.6
(22) Date of filing: 11.09.2023
(51) Int. Cl.: G05B 19/418, G06Q 10/06, G06Q 10/10, G06Q 50/04, B25J 9/16, G06F 30/13, G06F 30/17

(54) **METHOD AND SYSTEM FOR POSITIONING AN INDUSTRIAL ASSET IN A MANUFACTURING ENVIRONMENT**
VERFAHREN UND SYSTEM ZUR POSITIONIERUNG EINES INDUSTRIELLEN ASSETS IN EINER HERSTELLUNGSUMGEBUNG
PROCÉDÉ ET SYSTÈME DE POSITIONNEMENT D'UN ACTIF INDUSTRIEL DANS UN ENVIRONNEMENT DE FABRICATION

(30) Priority: 15.11.2022 EP 22207449
(43) Date of publication of application: 24.09.2025
(73) Proprietor: Siemens Aktiengesellschaft, 80333 München (DE)
(72) Inventor: HAZAN, Moshe, 4083918 Elad (IL)
(74) Representative: Siemens Patent Attorneys
(86) International application number: PCT/EP2023/074854
(87) International publication number: WO 2024/104631

(56) References cited:
- US-A1- 2015 278 406

## Description

### TECHNICAL FIELD

The present disclosure is directed, in general, to computer-aided design, visualization, and manufacturing ("CAD") systems, product lifecycle management ("PLM") systems, product data management ("PDM") systems, production environment simulation, and similar systems, that manage data for products and other items (collectively, "Product Data Management" systems or PDM systems). More specifically, the disclosure is directed to digital representation of a physical environment and the determination of object positions in such physical environment.

### BACKGROUND OF THE DISCLOSURE

Three-dimensional ("3D") digital models of physical environments are used for various tasks and purposes. For instance, usages of a 3D representation of a factory or of manufacturing assets can include, but are not limited by, manufacturing process analysis, manufacturing process simulation, equipment collision checks, and virtual commissioning.

As used herein the term manufacturing asset denote any resource, device, machinery, part and/or any other object, like machines, present in manufacturing lines, or more generally speaking, in a physical environment, and that are configured for executing manufacturing tasks or operations. For instance, examples of devices comprised in a physical or real manufacturing environment include, but are not limited by, industrial robots and their tools, transportation assets like e.g. conveyors, turn tables, safety assets like e.g. fences, gates, automation assets like e.g. clamps, grippers, fixtures that grasp parts and more.

In such physical environments, one problematic remains the planning of the position of fixed (or non-mobile) manufacturing assets, i.e. manufacturing assets that typically comprise a base that is, and is configured for remaining, at a fixed position with respect to said physical environment during manufacturing operations. Fixed manufacturing assets are typically affixed to a ground of said physical environment, their base being therefore prevented from moving from one position to another in said physical environment. An example of fixed manufacturing assets configured for being installed at a fixed position within said physical environment is an industrial robot having a base fixed to the ground while other parts of the industrial robot, like an articulated arm may move in a three-dimension (hereafter "3D") space. Typically, when a manufacturing line is built, a set of fixed manufacturing assets are installed along the manufacturing line, each at a specific position enabling the concerned fixed manufacturing asset to carry out a planned operation. Along the manufacturing line, the sequence of planned operations carried out by the different fixed assets enables for instance to create, from an initial raw product entering the line, a final product at the output of the line. The different fixed manufacturing assets of the line are thus configured for sequentially performing a set of manufacturing operations which results in the creation of said final product from the raw product. While the specific position of each of the fixed manufacturing assets has been defined in function of said manufacturing operations to be performed on said raw product, it may happen that, in the future, the manufacturing line be used for other (new) operations to be performed on said raw product or on another product. To adapt said manufacturing line to said other (new) operations, an operator may have to adjust or change said specific positions of one or several of the fixed manufacturing assets, and/or to adapt the fixed industrial asset to said other (new) operations. Said adjustments, adaptation, or changes have a cost in terms of time that the manufacturing line cannot produce, and effort for planning new specific positions and adaptation for the different fixed manufacturing assets. Therefore, depending on the specific position that has been initially allocated to a fixed manufacturing asset, e.g. to an industrial robot, more or less adjustments or changes will have to take place so that said fixed manufacturing asset can then efficiently achieve said other (new) operations. In other words, the specific position initially assigned to each fixed manufacturing asset of a manufacturing line impacts the number of adjustments or changes that will have to be implemented for adapting the manufacturing line to said other (new) operations.

Nowadays, solutions for determining a robot base position which minimizes energy consumption and task cycle time are known. This is for instance disclosed in US 2015/0278406 A1. However, no solution exists for determining a best position for a fixed manufacturing asset within a physical environment with respect to future potential tasks or operations, i.e. not yet known tasks/operations, that might have to be carried out by the considered fixed manufacturing asset. By "best position", it has to be understood a position for which unknown changes or adaptations that may occur in the future will require the minimum of changes or adjustments for the considered fixed manufacturing asset.

Therefore, improved systems and method for determining a position of a fixed manufacturing asset in a physical environment, typically a manufacturing environment like a manufacturing line, are desirable.

### SUMMARY OF THE DISCLOSURE

Various disclosed embodiments include methods, systems, and computer readable mediums for determining a position of a fixed manufacturing asset, e.g. an industrial robot, in a physical environment.

A method, as defined in independent claim 1, includes: by a computing system:
- receiving a virtual representation of said physical environment, comprising at least one planned manufacturing location, said planned manufacturing location being configured for defining a position, within said physical environment, where a planned manufacturing operation (i.e. a real manufacturing operation) has to be performed on a product. In other words, the planned manufacturing operation and planned manufacturing location correspond respectively to the real manufacturing operation that will have to be performed on a real product in the real physical environment, and the location, within said real physical environment, where said operation will have to take place. When considering designing a manufacturing line, the planned manufacturing location and the planned manufacturing operation have thus to be achieved by the final design of the manufacturing line;
- receiving a virtual representation of one or several fixed manufacturing assets, e.g. industrial robots, wherein each fixed manufacturing asset comprises a stationary base, typically designed for being fixed on, or supported by, a ground or wall or ceiling of said physical environment, and wherein the position of said stationary base within said physical environment has to be determined in function of said planned manufacturing location;
- receiving or determining, for each of said fixed manufacturing asset, a set of base positions, each base position being configured for enabling said fixed manufacturing asset to carry out said planned manufacturing operation on said product when its stationary base is installed or located at the considered said base position;
- receiving one or several rules, wherein each rule defines, for a real manufacturing task of a predefined set of real manufacturing tasks, that can notably be carried out on said product or on another product, a range of values that are authorized when performing said real manufacturing task, wherein said values are called hereafter "authorized values";
- for each real manufacturing task of said predefined set, generating a set of fake manufacturing locations in function of the rule(s) defined for the considered real manufacturing task, and optionally in function of the planned manufacturing location;
- rating each fake manufacturing location with a value or score, wherein the higher the score, the greater the probability of the fake manufacturing location to be a future realistic location for performing the real manufacturing task for which said fake manufacturing location has been generated. By "probability to be a future realistic location" it has to be understood that the score is an evaluation of the technical feasibility of performing said real manufacturing task at said fake manufacturing location, wherein the higher the score, the greater said technical feasibility;
- receiving, for each of said fixed manufacturing assets, a list of tools, wherein each tool is adapted to the considered fixed manufacturing asset and configured for enabling the latter to carry out one or several of said real manufacturing tasks of said predefined set;
- for each fixed manufacturing asset, computing all combinations of fixed manufacturing asset base positions and fixed manufacturing asset tools, and for each combination, listing all real manufacturing tasks that can be achieved by the considered combination;
- for each fixed manufacturing asset, filtering out all computed combinations for which the fixed manufacturing asset cannot carry out said planned manufacturing operation at said planned manufacturing location;
- for each remaining computed combination, determining a set of reachable fake manufacturing locations comprising all fake manufacturing locations of each of the sets of fake manufacturing locations generated for a real manufacturing task of said predefined set that is listed in said list of real manufacturing tasks defined for the considered combination and that can be reached by the fixed manufacturing asset defined according to the concerned combination;
- for each of said remaining computed combination, summing up the scores of the fake manufacturing locations comprised in said set of reachable fake manufacturing locations in order to obtain a final score for the concerned remaining computed combination;
- selecting, among the remaining computed combinations, the one characterized by the highest final score;
- positioning, in said virtual representation of the physical environment, the stationary base of the fixed manufacturing asset of the selected combination at the base position given in said selected combination.

A computing system, as defined in independent claim 11, comprising a processor and an accessible memory or database is also disclosed, wherein the data processing system is configured to carry out the previously described method.

The present invention proposes also a non-transitory computer-readable medium, as defined in independent claim 12, encoded with executable instructions that, when executed, cause one or more data processing systems to perform the previously described method.

Further advantageous features of the invention are defined in the dependent claims.

The foregoing has outlined rather broadly the features and technical advantages of the present disclosure so that those skilled in the art may better understand the detailed description that follows. Additional features and advantages of the disclosure will be described hereinafter that form the subject of the claims. Those skilled in the art will appreciate that they may readily use the conception and the specific embodiment disclosed as a basis for modifying or designing other structures for carrying out the same purposes of the present disclosure. Those skilled in the art will also realize that such equivalent constructions do not depart from the scope of the disclosure in its broadest form

Before undertaking the DETAILED DESCRIPTION below, it may be advantageous to set forth definitions of certain words or phrases used throughout this patent document: the terms "include" and "comprise," as well as derivatives thereof, mean inclusion without limitation; the term "or" is inclusive, meaning and/or; the phrases "associated with" and "associated therewith," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, or the like; and the term "controller" means any device, system or part thereof that controls at least one operation, whether such a device is implemented in hardware, firmware, software or some combination of at least two of the same. It should be noted that the functionality associated with any particular controller may be centralized or distributed, whether locally or remotely. Definitions for certain words and phrases are provided throughout this patent document, and those of ordinary skill in the art will understand that such definitions apply in many, if not most, instances to prior as well as future uses of such defined words and phrases. While some terms may include a wide variety of embodiments, the appended claims may expressly limit these terms to specific embodiments.

### BRIEF DESCRIPTION OF THE DRAWINGS

For a more complete understanding of the present disclosure, and the advantages thereof, reference is now made to the following descriptions taken in conjunction with the accompanying drawings, wherein like numbers designate like objects, and in which:
Figure 1 illustrates a block diagram of a computing system in which an embodiment can be implemented.
Figure 2 illustrates a flowchart describing a preferred embodiment of a method for determining a position of a fixed manufacturing asset in a physical environment according to the invention.
Figure 3 schematically illustrates a manufacturing line.
Figure 4 schematically illustrates a top view of the manufacturing line of Figure 3.

### DETAILED DESCRIPTION

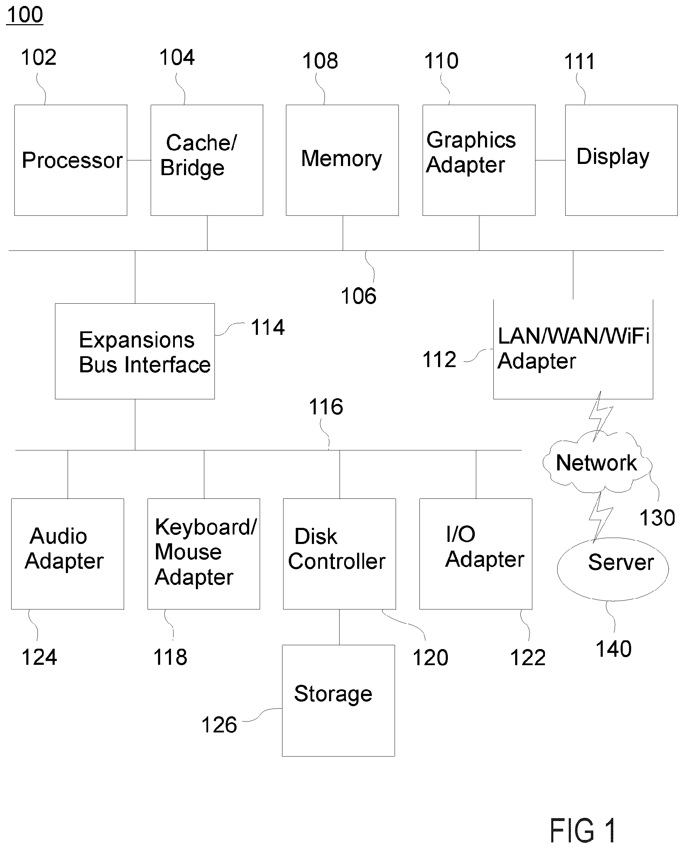

FIGURES 1 through 4, discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged device. The numerous innovative teachings of the present application will be described with reference to exemplary non-limiting embodiments.

Nowadays, designing and building a manufacturing line is made by taking account of currently planned operations. Fixed manufacturing assets, like industrial robots, are thus installed along the manufacturing line so that they can carry out tasks that are planned to be performed on a product. Problems arise when said manufacturing line is used for carrying out manufacturing operations for which it was not initially designed, i.e. when a manufacturing line initially designed for carrying out a first set of manufacturing operations has to carry out a second set of manufacturing operations comprising at least one manufacturing operation for which the manufacturing line was not initially designed. In such a case, some fixed manufacturing assets may have to be adapted and/or moved from an initial base position to a new base position. The present invention proposes to mitigate the changes or adaptations that have to take place in the future by proceeding to a smart positioning of the fixed manufacturing assets.

Figure 1 illustrates a block diagram of a computing system 100 that can carry out said smart positioning according to the invention. Said computing system 100 is for instance a data processing system in which an embodiment of the claimed method can be implemented, for example as a PDM system particularly configured by software or otherwise to perform the processes as described herein, and in particular as each one of a plurality of interconnected and communicating systems as described herein. The computing system 100 illustrated can include a processor 102 connected to a level two cache/bridge 104, which is connected in turn to a local system bus 106. Local system bus 106 may be, for example, a peripheral component interconnect (PCI) architecture bus. Also connected to local system bus in the illustrated example are a main memory 108 and a graphics adapter 110. The graphics adapter 110 may be connected to display 111.

Other peripherals, such as local area network (LAN) / Wide Area Network / Wireless (e.g. WiFi) adapter 112, may also be connected to local system bus 106. Expansion bus interface 114 connects local system bus 106 to input/output (I/O) bus 116. I/O bus 116 is connected to keyboard/mouse adapter 118, disk controller 120, and I/O adapter 122. Disk controller 120 can be connected to a storage 126, which can be any suitable machine usable or machine readable storage medium, including but are not limited to nonvolatile, hard-coded type mediums such as read only memories (ROMs) or erasable, electrically programmable read only memories (EEPROMs), magnetic tape storage, and user-recordable type mediums such as floppy disks, hard disk drives and compact disk read only memories (CD-ROMs) or digital versatile disks (DVDs), and other known optical, electrical, or magnetic storage devices.

Also connected to I/O bus 116 in the example shown is audio adapter 124, to which speakers (not shown) may be connected for playing sounds. Keyboard/mouse adapter 118 provides a connection for a pointing device (not shown), such as a mouse, trackball, track pointer, touchscreen, etc.

Optionally, an imaging device, comprising for instance a laser scanner and/or a camera, is part of the computing system 100 or connected to the latter for providing it with a digital image of the physical environment. Said digital image might be used for determining the position of the fixed manufacturing assets in the virtual representation of said physical environment. By implementing then the presently claimed concept, this enables then to find the best location of each fixed manufacturing asset in the real physical environment.

Those of ordinary skill in the art will appreciate that the hardware illustrated in Figure 1 may vary for particular implementations. For example, other peripheral devices, such as an optical disk drive and the like, also may be used in addition or in place of the hardware illustrated. The illustrated example is provided for the purpose of explanation only and is not meant to imply architectural limitations with respect to the present disclosure.

A computing system 100 in accordance with an embodiment of the present disclosure can include an operating system employing a graphical user interface. The operating system permits multiple display windows to be presented in the graphical user interface simultaneously, with each display window providing an interface to a different application or to a different instance of the same application. A cursor in the graphical user interface may be manipulated by a user through the pointing device. The position of the cursor may be changed and/or an event, such as clicking a mouse button, generated to actuate a desired response.

One of various commercial operating systems, such as a version of Microsoft Windows^{™}, a product of Microsoft Corporation located in Redmond, Wash. may be employed if suitably modified. The operating system is modified or created in accordance with the present disclosure as described.

LAN/ WAN/Wireless adapter 112 can be connected to a network 130 (not a part of computing system 100), which can be any public or private data processing system network or combination of networks, as known to those of skill in the art, including the Internet. The computing system 100 can communicate over network 130 with server system 140, which is also not part of the computing system 100, but can be implemented, for example, as a separate data processing system.

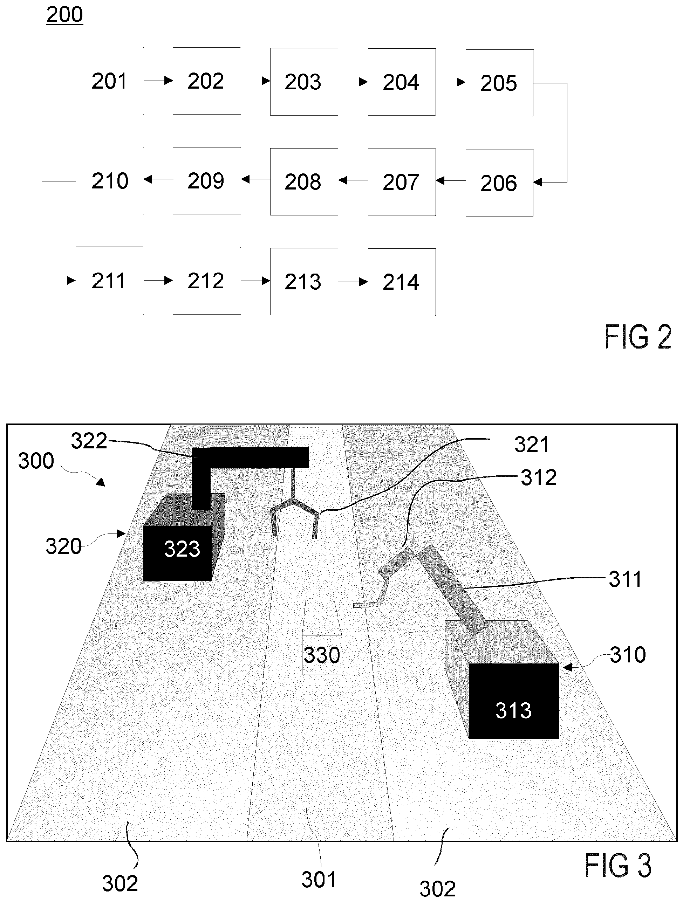

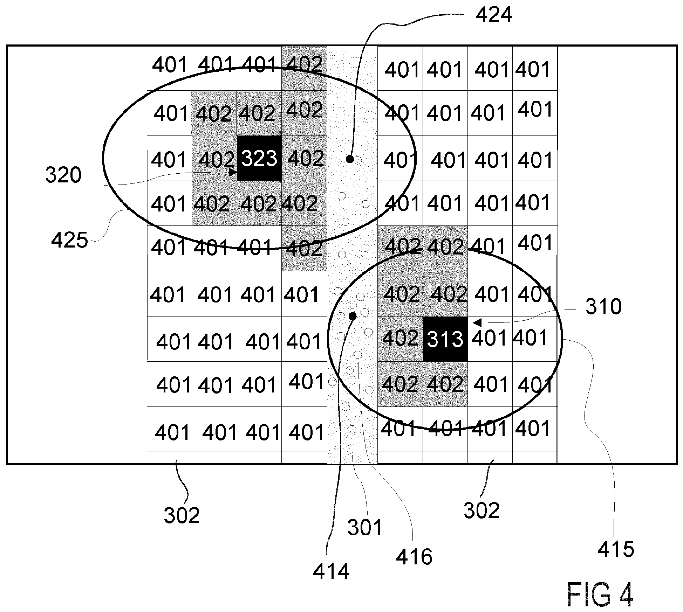

Figure 2 illustrates a flowchart of a method for determining a position (namely the "best position") of a fixed manufacturing asset in a physical environment, for instance a manufacturing line. The method will be explained in details hereafter in connection with Figure 3 and Figure 4 which present respectively, and very schematically, a 3D view of a manufacturing line 300, and a top view of said manufacturing line 300. Said manufacturing line 300 comprises for instance a first area 301 assigned to the displacement of a product 330 along the manufacturing line, and second areas 302 where fixed manufacturing assets, like a first industrial robot 310 and a second industrial robot 320, are located. The product 330 enters the manufacturing line 300 as a raw product and goes out of said manufacturing line as a final product after a sequential set of manufacturing operations realized by the fixed manufacturing assets took place on said product 330.

Said fixed manufacturing assets comprise a stationary base that is supported or affixed to the ground and which cannot move. The stationary base according to the invention is thus a motionless base that remains immobile in function of the time. While the example of stationary bases affixed to the ground is taken for the purpose of illustration in Fig. 3, the present invention also works for stationary bases that have to be fixed to the ceiling and/or a wall and/or ground. Preferentially, a fixed manufacturing asset according to the invention comprises one or several movable parts and moving means for moving each movable part. Such a movable part is for instance an articulated arm 311, 312, 322, of the first and/or second industrial robots 310, 320 and the moving means are for instance controllable actuators, which provide to the fixed manufacturing asset the ability to move said movable part with respect to its stationary base. This enables the fixed manufacturing asset to place for instance an extremity of said movable part at some location within a 3D space surrounding the stationary base of the fixed manufacturing asset. The movable part might comprise or be equipped with one or several tools, which can therefore be moved from a first position towards a second position with respect to the stationary base. This typically enables a fixed manufacturing asset to position said tool at different locations with respect to the fixed position of the stationary base. For instance, industrial robots might be equipped or might comprise one or several of the following tools, a jaw, and/or a wrench 321, and/or welding tool, and/or drilling tool, and/or gripping tool, etc., which are typically mounted on one or several articulated arms 312, 322, 313 enabling the industrial robot to move said tool with respect to its stationary base 313, 323 in order to carry out one or several tasks, like welding, drilling, rotating a component, fixing components, and the like, at a location distant from its stationary base. Therefore, for each fixed manufacturing asset, like the industrial robots 310, 320, the position of the stationary base 313, 323 will determine a set of positions or locations surrounding the stationary base and that can be reached by said movable part, in particular by a tool installed on or fixed to said movable part, in a 3D space surrounding the fixed manufacturing asset base. This is schematically illustrated in Fig. 4, i.e. in the top view of the manufacturing line shown in Fig. 3. The respective position of the stationary base 313 of the first industrial robot 310 and of the stationary base 323 of the second industrial robot 320 are represented by a black square labeled with the reference number of the corresponding stationary base 313 or 323. For each of said first and second industrial robots 320, 330, white squares 401 and grey squares 402 illustrate alternative positions for their respective stationary base 313, 323 along the first area 301. The black squares 313, 323 represent each the position within the second area 302 where the stationary base of the corresponding industrial robot 310, 320 has been affixed to the ground. Said position enables the industrial robot to carry out a task or an operation at a first location 414 for the first industrial robot 310 and at a second location 424 for the second industrial robot 320. For the first industrial robot 310, a first ellipse 415 delimits all positions that can be reached by the first industrial robot 310, and a second ellipse 425 delimits all positions that can be reached by the second industrial robot 320. In other words, positions inside these ellipses can be reached by the respective industrial robot, for instance by a tool supported by an articulated arm of the considered industrial robot. While Fig. 4 presents a very schematic view, it has to be considered that the positions that can be reached by an industrial robot, or more generally speaking, by a fixed manufacturing asset, take place in a delimited 3D volume with respect to the stationary base position. Such 3D volumes are also called "reachability maps" and are known in the art. Typically, a reachability map describes the reachability space of a specific fixed manufacturing asset, e.g. of a specific industrial robot, in function of an attached tool and/or surrounding obstacles, and/or own kinematic and geometric constraints.

In such context, one problematic is to determine, when planning and building a manufacturing line and/or when adapting an existing manufacturing line, the stationary base position, among all possible positions for said stationary base 323, 313 of the considered fixed manufacturing asset(s), that will give the most flexibility to the considered fixed manufacturing asset by maximizing the technical feasibility of the highest number of tasks, this enabling to find a best position with respect to future non-planned tasks or operations that can take place for the considered fixed manufacturing asset in the future. By "flexibility", it has to be understood the ability for the considered fixed manufacturing asset to carry out a certain number of tasks or operations within its surrounding environment. To solve this problematic, the present invention proposes notably to implement, by the computing system 100, a method configured for finding, in a real physical environment, a stationary base position for a fixed manufacturing asset that maximizes the technical feasibility of the highest number of tasks that can be performed by said fixed manufacturing asset. The method 200 according to the invention comprises notably the following steps:

At step 201, the computing system 100 according to the invention acquires or receives a virtual representation of said physical environment, e.g. of said manufacturing line 300. Said virtual representation is for instance the representation of a real physical environment, which may comprise notably already installed manufacturing assets. The goal is to determine, within said real physical environment, the best position for at least one fixed manufacturing asset (e.g. a new one, or a new position for an already installed fixed manufacturing asset) that has to be installed in said real physical environment. For instance, when taking the example provided by the manufacturing line 300 of Fig. 3 and 4, it may happen that the physical environment comprises already the first industrial robot 313, while the second industrial robot 323 is not yet present in said physical environment, and its position within said physical environment has to be determined. In such a case, the virtual representation of the physical environment will comprise the first industrial robot, but not yet the second industrial robot, and the goal will be to determine virtually the best position of the second industrial robot in said physical environment before effectively installing it at said best position in the real world.

According to the present invention, said virtual representation of the physical environment comprises at least one planned manufacturing location. In other words, for each fixed manufacturing asset whose position has to be determined, at least a planned manufacturing location is defined within the physical environment (and thus also in its virtual representation) as constraint to be satisfied when positioning the stationary base of said fixed manufacturing asset within said physical environment. Said planned manufacturing location defines a position, within said physical environment, where a planned real manufacturing operation has to be performed on a product. In other words, the planned real manufacturing operation and planned manufacturing location correspond respectively to a real manufacturing operation that will have to be performed on a real product in the real physical environment, and to the location, within said real physical environment, where said real manufacturing operation will have to take place. The planned real manufacturing operation and planned manufacturing location are therefore "input" parameters in the problem of determining the best position for the stationary base of the fixed manufacturing asset. Indeed, a manufacturing line is first designed for achieving a specific sequence of operations on a product. This specific sequence of operations defines for each operation, a location where it has to be performed, notably with respect to the product shape. Therefore, when considering designing a manufacturing line, and thus when searching for the best position for the stationary base of a fixed manufacturing asset, the planned manufacturing location and the planned manufacturing operation are fixed constraints that must be satisfied by the final design of the manufacturing line, i.e. by the chosen/determined best position. According to the present invention, the planned manufacturing operation defines notably a sequence of manufacturing tasks that have to be performed. The planned manufacturing location may define for each task of said sequence a position within the real physical environment. In other words, the location of the planned manufacturing operation may define one or several positions wherein planned manufacturing tasks have to be performed.

At step 202, the computing system 100 receives or acquires a virtual representation of one or several fixed manufacturing assets, e.g. industrial robots 310, 320, whose respective stationary base position within said physical environment has to be determined in function of at least said planned manufacturing location. In other words, the computing system 100 may take into consideration several fixed manufacturing assets, e.g. several types of industrial robots, for carrying out said real manufacturing operation, and the present method will determine which one and at which stationary base position will be the best for carrying out said real manufacturing operation. At the end, the computing system 100 will thus be able to output not only the best position for the stationary base of the considered fixed manufacturing assets, but also which fixed manufacturing asset is the most suitable for offering a best flexibility. An operation according to the present invention comprises typically one or several tasks carried out by the fixed manufacturing asset. For instance, an operation performed by an industrial robot may comprise gripping a component at a first position, moving said component at a second position, and welding said component to a housing. Each operation may thus comprise a sequence of tasks to be completed by the fixed manufacturing asset. Preferentially, for each received or acquired virtual representation of a fixed manufacturing asset, the computing system 100 receives or acquires a set of tools that can be used by said fixed manufacturing asset and a set of manufacturing tasks that can be performed by said fixed manufacturing asset, notably with and without said tools.

At step 203, the computing system 100 is configured for receiving or determining, for the stationary base of each of said fixed manufacturing asset, a set of base positions enabling said fixed manufacturing asset to carry out said planned manufacturing operation on said product. In particular, the computing system is configured for determining, in said virtual representation of the physical environment and from the knowledge of the planned manufacturing location and said delimited 3D volume, an area located on the ground and/or on a wall and/or on a ceiling of said physical environment, which enables the considered fixed manufacturing asset to carry out the planned manufacturing operation at said planned manufacturing location when its stationary base is installed within said area. Of course, several planned manufacturing locations might also be considered, the present concept applying then mutatis mutandis. For instance, when considering the schematic illustration of a manufacturing line of Fig. 4, among the grey squares 402 and white squares 401 surrounding each of the industrial robots 310 and 320, only the grey squares 402 enable the considered industrial robot to reach the planned manufacturing location corresponding to the first location 414 for the first industrial robot 310 and to the second location 424 for the second industrial robot 320 when considering respectively the first ellipse 415 and second ellipse 425 which illustrate the reachability space for each industrial robot. While Fig. 4 shows an example wherein the considered base positions for each industrial robot 310, 320 is limited to one of the second areas 302, (i.e. they are only located at one side of the first area 301), the claimed method is able to consider potential positions for a fixed manufacturing asset at both sides of the first area 301. The computing system 100 may then determine said set of base positions by discretizing said area located on the ground and/or on a wall and/or on a ceiling of said physical environment using known in the art techniques, giving rise for instance to the set of grey squares 402 in the case illustrated by Fig. 4. At the end of step 203, a set of positions for the stationary base of each considered fixed manufacturing asset is thus obtained.

At step 204, the computing system 100 receives or acquires one or several rules, wherein each rule defines, for a real manufacturing task of a predefined set of real manufacturing tasks that can be carried out on said product 330 or on another product, a range of values that are authorized when performing said real manufacturing task, wherein said values are called hereafter "authorized values". The rule may define for instance a deviation from a given position, angle, length, etc., or a given tolerance or deviation with respect to input manufacturing physical parameters that are used for manufacturing the product. A rule can also define an area or volume wherein a real manufacturing task is authorized and can be performed. In particular, a same rule might be assigned to two different real manufacturing tasks, or each real manufacturing task has a different rule assigned to it. For instance, for a given welding position of a welding spot, the authorized values define a set of positions on the product (and therefore a space within the physical environment) that are permitted for said welding spot, e.g. a set of positions surrounding the given welding position. The rules might be given by an operator for each real manufacturing task. Alternatively, or additionally, permitted deviations or tolerances might be automatically acquired by the computing system 100 from a manufacturing operation management system and used for automatically creating rules for each real manufacturing task. A rule defines thus authorized values for performing, or with respect to, a real manufacturing task, wherein said authorized values define geometric and/or geographic constraints and/or positions (in the real world) with respect to a planned manufacturing location where said real manufacturing task has to be performed (e.g. a tolerance with respect to a welding line) and/or with respect to said physical environment (e.g. a space that comprises an object preventing a motion of an industrial robot arm, or that is defined as a security space in said physical environment).

At step 205, for each real manufacturing task of said predefined set, the computing system 100 is configured for automatically generating a set of fake manufacturing locations in function of said rules and optionally, in function of the planned manufacturing location. Such fake manufacturing locations are represented by the circles 416 in Fig. 4 for the planned manufacturing location represented by the first location 414. In particular, the computing system 100 might be configured for generating said fake manufacturing locations within a predefined 2D or 3D space, which can be user-defined, or automatically defined by the computing system 100 in function of at least one of said rules, and/or in function of features of the physical environment, like a presence of obstacles, objects, a security zone, etc., which prevent a completion of a manufacturing task within the space occupied by said feature. Each fake manufacturing location may define a single point within the space of the physical environment, or an area, or a volume, depending notably on the considered task. Said fake manufacturing locations might be notably randomly generated by the computing system, for instance within a predefined space (that is for instance defined according to one of said rules) using known in the art techniques. Preferentially, a normal vector is generated for each fake manufacturing location, said normal vector indicating a direction perpendicular to a surface where said real manufacturing task would have to take place. For instance, a drilling operation could take place perpendicularly to the surface, and thus along said normal vector at said fake manufacturing location, while a welding operation could take place along the surface, and thus perpendicularly to said normal vector at said fake manufacturing location. In particular, the direction of the normal vector may impact or modify the score assigned to a fake location as explained below.

At step 206, the computing system 100 is configured for automatically rating each fake manufacturing location with a value or score. In particular, said score might be calculated by the computing system 100 in function of a set of parameters comprising for instance: a distance separating the planned manufacturing location from the fake manufacturing location, wherein notably the greater the distance, the lower the score; and/or a number of other planned manufacturing locations within a predefined volume surrounding the fake location, wherein notably the greater the number, the lower the score; and/or a distance separating said other planned manufacturing locations from the considered fake location, wherein notably, the greater said distance, the lower said score; and/or a probability of collision with another fixed or a mobile manufacturing asset when performing said task at said fake location, wherein notably the higher the probability, the lower the score; and/or a type of real manufacturing task that will take place at said fake manufacturing location (e.g. the score is different for laser welding than arc based welding), and/or a deviation from a planned manufacturing location, wherein the greater the deviation, the lower the score; and/or whether reaching a fake manufacturing location requires an adaptation of the configuration of the fixed manufacturing asset (e.g. a mechanical adaptation, like changing a joint value of the fixed manufacturing asset), wherein increasing the number of adaptations decreases the value of the score; and/or a direction of said normal vector. In particular, the score is a positive or negative integer . In particular, the computing system 100 might use a weighting function applied to said set of parameters for calculating said score. According to the present invention, the higher the score, the greater the probability of the fake manufacturing location to be a future realistic location. Thus, said score assigned to each fake manufacturing location represents an evaluation of a feasibility of the concerned manufacturing task at said fake manufacturing location when considering notably the environment surrounding said fake location. Preferentially, said score is 0 if the computing system determines that a collision with an object or obstacle takes place at said fake manufacturing location. Said score is notably evaluated in function of the known planned manufacturing location and a set of parameters capable of characterizing the "position" of said fake manufacturing location with respect to its surrounding environment.

At step 207, the computing system 100 is configured for receiving or acquiring, for each of said fixed manufacturing assets, a list of tools, wherein each tool is adapted to the considered fixed manufacturing asset and configured for enabling the latter to carry out one or several of said real manufacturing tasks of said predefined set. In particular, depending on the considered fixed manufacturing asset, only a limited list of tools might be used by the latter. For instance, the first industrial robot 310 might be configured for controlling a welding tool or a drilling tool, but no gripping tool. At the opposite, the second industrial robot might be configured for controlling a gripping tool, a rotating tool, but neither a welding tool, nor a drilling tool. Therefore, the set of tools that can be assigned to each specific fixed manufacturing asset is a known parameter that defines a subset of tasks that can be carried out by the concerned fixed manufacturing asset, notably in addition to tasks that can be carried out by the fixed manufacturing asset itself, i.e. free of any tool. One can indeed make a distinction between a first subset of manufacturing tasks that can be carried out by the fixed manufacturing asset itself (i.e. in its nominal configuration) and a second subset of manufacturing tasks comprising additional manufacturing tasks that can be carried out by said fixed manufacturing asset equipped with one or several tools, each tool or combination of tools enabling the latter to carry out at least one of said additional manufacturing task. Said tools are preferably removable tools, in that they can be mounted on or dismounted from the considered fixed manufacturing asset, notably automatically (e.g. by carrying out an automatic tool change).

At step 208, the computing system 100 is configured for computing, for each fixed manufacturing asset, all combinations of fixed manufacturing asset base positions and fixed manufacturing asset tools, and for providing for each combination the list of real manufacturing tasks that can be achieved by the considered combination. For each fixed manufacturing asset, each combination combines thus an element from the set of base positions with an element of the list of tools, the combinations being different from each other, said "all combinations" including notably the combination wherein the considered fixed manufacturing asset has no tool, i.e. is in its nominal configuration. Then, for each combination, the computing system 100 provides the list of manufacturing tasks that can be carried out by the concerned fixed manufacturing asset characterized by said combination. For instance, if the virtual representations of two industrial robots R1 and R2 have been acquired by the computing system 100 and that for each industrial robot R1 and R2, a same set of positions P1, P2, P3 has been determined for their respective base, and that the industrial robot R1 is capable of performing the task T4 (e.g. gripping) and T5 (e.g. rotating) in its nominal configuration, and is further configured for using the tools G1 and G2, while the industrial robot R2 is capable of performing the tasks T4, T5 and T6 (e.g. lifting and translating) in its nominal configuration, and is further able to use the tools G2 and G3, wherein the tool G1 enables to perform the real manufacturing task T1, the tool G2 enables to perform the real manufacturing tasks T1 and T2, the tool G3 enables to perform the manufacturing task T3, then said combinations might be expressed as follows:
- For the first robot R1: (R1,P1,T4,T5), (R1,P2,T4,T5,), (R1,P1,G1,T1,T4,T5), (R1,P1,G2,T1,T2,T4,T5), (R1, P2, G1, T1,T4,T5),..., (R1,P3,G2,T1,T2,T4,T5);
- For the second robot R2: (R2,P1,T4,T5,T6), (R2,P2,T4,T5,T6), (R2,P1,G2,T1,T2,T4,T5,T6), ..., (R2,P3,G3,T3,T4,T5,T6).

At step 209, the computing system 100 is configured for filtering out, for each fixed manufacturing asset, all computed combinations for which the fixed manufacturing asset cannot carry out said planned manufacturing operation that has to take place at said planned manufacturing location. In other words, the computing system 100 is configured for only keeping, among all computed combinations, those for which the fixed manufacturing asset is able to carry out the planned manufacturing operation, the other combinations being preferentially discarded. For this purpose, the computing system 100 may compare the list of real manufacturing tasks assigned to each combination to the manufacturing tasks defined by said planned manufacturing operation in the sequence of manufacturing tasks, and discard all combinations whose list does not include all the real manufacturing tasks defined by said planned manufacturing operation. For instance, with respect to the previous example of combinations, if the planned manufacturing operation comprises performing the tasks T1, T4 and T5, then all combinations that do not comprise in the list of real manufacturing tasks the tasks T1, T4 and T5 are filtered out. The filtered-out combinations are not considered by the computing system 100 for further processing. Additionally, the computing system may filter out all combinations for which a collision of the moving part of the fixed manufacturing asset with an object (mobile or fixed) occurs when having to perform said planned manufacturing operation at said planned manufacturing location and/or all combinations that do not enable the fixed manufacturing asset to reach said planned manufacturing location for performing said planned manufacturing operation. This filtering out aims thus to discard all combinations that are technically unfeasible when considering the planned manufacturing operation.

At step 210, for each remaining computed combination, the computing system 100 is configured for determining, for the listed real manufacturing tasks of the concerned combination, a set of reachable fake manufacturing locations, the latter comprising all fake manufacturing locations of each of the sets of fake manufacturing locations generated for a real manufacturing task listed in said list of real manufacturing tasks that can be reached by the fixed manufacturing asset defined or characterized according to the concerned combination. In other words, the computing system 100 is configured for searching, within each set of fake manufacturing locations associated to a manufacturing task listed in the list of manufacturing tasks defined for the considered combination, all fake manufacturing locations that can be reached by the fixed manufacturing asset defined according to the combination when performing the concerned manufacturing task, i.e. defined by the fixed manufacturing asset having its stationary base at the position defined by said combination and comprising the tool defined by said combination for performing the concerned manufacturing task listed in said combination. The fake manufacturing locations that are found to be reachable are then classified in said set of reachable fake manufacturing locations, i.e. a single set of reachable fake manufacturing locations is determined for each combination. The expression "reachable" when considering a fake manufacturing location means that the manufacturing task defined in said combination can be performed by the fixed manufacturing asset when having its stationary base located at the position defined by said combination, and taking into account notably said normal vector. For instance, when considering a drilling task as manufacturing task, the normal vector can be defined for providing a drilling direction at said fake manufacturing location, and the computing system is then configured for determining whether said drilling direction at said fake manufacturing location can be achieved or not by the considered fixed manufacturing asset, and if yes, then the fake manufacturing location is classified as a reachable fake manufacturing location, otherwise it is rejected. Therefore, and preferentially, the computing system may use said normal vector defined for each fake manufacturing location as additional constraint for determining whether a fake manufacturing location is reachable or not for a considered manufacturing task. For instance, if said combination defines for the robot R1, a position P2, a tool T3, for performing a welding task, then the computing system according to the invention will determine whether said welding task can be performed by the tool T3 at said fake manufacturing location perpendicularly and/or in parallel (depending on the welding task) to the normal vector when the stationary base of robot R1 is located at position P2. If yes, then the fake manufacturing location is classified in the set of reachable fake manufacturing locations, otherwise, it is discarded. In particular, the computing system may determine, from the virtual representation of the fixed manufacturing asset, whether a pose exists, wherein the stationary base of the fixed manufacturing asset is located at said position defined by the combination, the fixed manufacturing asset comprises said tool defined by the combination, and is capable of performing the manufacturing task of said combination for which said set of fake manufacturing locations currently tested has been generated. In other words, the computing system 100 is able to simulate different poses of the considered fixed manufacturing asset in order to determine whether a fake manufacturing location can be reached.

Preferentially, the computing system 100 according to the invention comprises a set of reachability maps stored in a database of the computing system 100. Each reachability map defines, for a specific fixed manufacturing asset, a set of positions with respect to the position of the fixed manufacturing asset stationary base that can be reached by a part of the considered fixed manufacturing asset, said part being for instance a tool of the fixed manufacturing asset, or an extremity of a moving part of the fixed manufacturing asset. In such a case, the set of reachable fake manufacturing locations can be obtained by the computing system by determining the reachability of the considered fake manufacturing location from the reachability map for the fixed manufacturing asset defined according to the considered combination. This advantageously avoids the computing system simulating the fixed manufacturing asset, making the claimed method more efficient.

At step 211, the computing system 100 is configured for summing up, for each of said remaining computed combination, the scores of the fake manufacturing locations comprised in said set of reachable fake manufacturing locations in order to obtain a final score for the concerned remaining computed combination. In other words, the computing system 100 is configured for summing, for each of the remaining computed combinations, the scores assigned to the fake manufacturing locations comprised in said set of reachable fake manufacturing locations. In such a case, the higher the final score, the higher the flexibility of the fixed manufacturing asset defined by said combination.

At step 212, the computing system 100 is configured for selecting, among the remaining computed combination, the one characterized by the highest final score. The selected combination defines thus the fixed manufacturing asset offering the best adaptability to future changes (in particular in terms of technical feasibility), when using the tool and the base position defined by the selected combination.

At step 213, the computing system 100 is configured for positioning, in said virtual representation of the physical environment, the fixed manufacturing asset of the selected combination, wherein its stationary base is positioned at said base position defined by the selected combination, and the fixed manufacturing asset comprises said tool defined by the selected combination. The virtual representation of the selected fixed manufacturing asset, i.e. of the fixed manufacturing asset of the selected combination, might then be used by the computing system 100 for performing a simulation of said physical environment comprising the selected fixed manufacturing asset. Preferentially, the computing system 100 is then configured for displaying, e.g. on a screen, the virtual representation of said physical environment comprising the selected fixed manufacturing asset. This enables for instance a user to proceed to additional checks or changes with respect to the design of a manufacturing line before effectively building the latter or installing components/equipment (e.g. a new industrial robot) of the latter in the real world. For instance, this might enable the user to set up or adapt a security zone for operators around the stationary base position of the selected fixed manufacturing asset.

At step 214, and preferentially, the method according to the invention comprises building in said physical environment, i.e. in the real world, a manufacturing line comprising the selected fixed manufacturing asset with its stationary base installed at said base position defined by the selected combination, and equipped with said tool defined in said selected combination.

Advantageously, the method according to the invention enables thus to construct a manufacturing line, wherein the position of each fixed manufacturing asset has been finely tuned for providing the best flexibility and adaptability to future changes in the tasks that said manufacturing line will have to carry out. This is of a great help for designing and building new manufacturing lines, as well for adapting existing manufacturing lines, e.g. for determining the best position of a new industrial robot within an existing manufacturing line. Preferentially, the present invention encompasses building a real manufacturing line comprising positioning one or several fixed manufacturing assets within said physical environment comprising said real manufacturing line, wherein the position of the stationary base of at least one of said fixed manufacturing assets, e.g. of an industrial robot, is determined according to the claimed method, and installing, e.g. fixing, the stationary base of said fixed manufacturing asset at said base position determined according to the claimed method. The present invention provides thus clear technical advantages compared to existing techniques in that it provides a smart positioning of each fixed manufacturing asset that maximizes the technical feasibility of the greatest number of manufacturing tasks.

In embodiments, the term "receiving", as used herein, can include retrieving from storage, receiving from another device or process, receiving via an interaction with a user or otherwise.

Those skilled in the art will recognize that, for simplicity and clarity, the full structure and operation of all data processing systems suitable for use with the present disclosure is not being illustrated or described herein. Instead, only so much of a data processing system as is unique to the present disclosure or necessary for an understanding of the present disclosure is illustrated and described. The remainder of the construction and operation of data processing system 100 may conform to any of the various current implementations and practices known in the art.

It is important to note that while the disclosure includes a description in the context of a fully functional system, those skilled in the art will appreciate that at least portions of the present disclosure are capable of being distributed in the form of instructions contained within a machine-usable, computer-usable, or computer-readable medium in any of a variety of forms, and that the present disclosure applies equally regardless of the particular type of instruction or signal bearing medium or storage medium utilized to actually carry out the distribution. Examples of machine usable/readable or computer usable/readable mediums include: nonvolatile, hard-coded type mediums such as read only memories (ROMs) or erasable, electrically programmable read only memories (EEPROMs), and user-recordable type mediums such as floppy disks, hard disk drives and compact disk read only memories (CD-ROMs) or digital versatile disks (DVDs).

Although an exemplary embodiment of the present disclosure has been described in detail, those skilled in the art will understand that various changes, substitutions, variations, and improvements disclosed herein may be made without departing from the scope of the disclosure in its broadest form.

None of the description in the present application should be read as implying that any particular element, step, or function is an essential element which must be included in the claim scope: the scope of patented subject matter is defined only by the appended claims.

## Claims

1. A method for determining a position of a fixed manufacturing asset (310,320) within a physical environment (300), the method comprising,
by a computing system (100):
- receiving (201) a virtual representation of said physical environment (300), comprising at least one planned manufacturing location, said planned manufacturing location being configured for defining a position, within said physical environment (300), where a planned manufacturing operation has to be performed on a product (330);
- receiving (202) a virtual representation of one or several fixed manufacturing assets (310, 320), each fixed manufacturing asset comprising a stationary base (313, 323);
- receiving or determining (203), for each of said fixed manufacturing assets, a set of base positions enabling said fixed manufacturing asset to carry out said planned manufacturing operation on said product (330);
- receiving (204) one or several rules, wherein each rule defines, for a real manufacturing task of a predefined set of real manufacturing tasks a range of values that are authorized when performing said real manufacturing task;
- for each real manufacturing task of said predefined set, generating (205) a set of fake manufacturing locations in function of the rule defined for the concerned real manufacturing task;
- rating (206) each fake manufacturing location with a score, wherein the higher the score, the greater the probability of the fake manufacturing location to be a future realistic location;
- receiving (207), for each of fixed manufacturing assets, a list of tools, wherein each tool is adapted to said fixed manufacturing asset and configured for enabling the latter to carry out one or several of said real manufacturing tasks of the predefined set;
- for each fixed manufacturing asset, computing (208) all combinations of fixed manufacturing asset base positions and fixed manufacturing asset tools, and listing for each combination the real manufacturing tasks that can be achieved by the considered combination;
- for each fixed manufacturing asset, filtering out (209) all computed combinations that cannot carry out said planned manufacturing operation;
- for each remaining computed combination, determining (210) a set of reachable fake manufacturing locations comprising all fake manufacturing locations of each of the sets of fake manufacturing locations generated for a real manufacturing task listed in the list of real manufacturing tasks for the considered combination and that can be reached by the fixed manufacturing asset (310,320) defined according to the concerned combination;
- for each of said remaining computed combination, summing up (211) the scores of the fake manufacturing locations comprised in said set of reachable fake manufacturing locations in order to obtain a final score for the concerned remaining computed combination;
- selecting (212), among the remaining computed combination, the one **characterized by** the highest final score;
- positioning (213), in said virtual representation of the physical environment, the stationary base of the fixed manufacturing asset of the selected combination at the base position given in said selected combination.

2. The method according to claim 1, wherein the fixed manufacturing asset is an industrial robot.

3. The method according to claim 1 or 2, comprising using a reachability map for determining whether a fixed manufacturing asset can reach a fake manufacturing location.

4. The method according to one of the claims 1 or 3, wherein said tasks are one or several of the following:
- rotating;
- translating from a first position towards a second position;
- welding;
- drilling;
- gripping;
- compressing;
- painting;
- actuating;
- lifting.

5. The method according to one of the claims 1 to 4, wherein said rules define a deviation from a given position, and/or from an angle, and/or from length, and/or a given tolerance with respect to an input manufacturing physical parameter used for manufacturing the product, and/or an area or volume wherein a real manufacturing task is authorized.

6. The method according to one of the claims 1 to 5, wherein said score is an evaluation of a technical feasibility of performing said real manufacturing task at said fake manufacturing location, the higher the score, the higher said technical feasibility.

7. The method according to one of the claims 1 to 6, wherein said score is calculated in function of a set of parameters comprising a distance separating the planned manufacturing location from the fake manufacturing location, and/or a number of other planned manufacturing locations within a predefined volume surrounding the fake manufacturing location, and/or a distance separating said other planned manufacturing locations from the considered fake manufacturing location, and/or a probability of collision with another fixed or a mobile manufacturing asset when performing said task at said fake manufacturing location, and/or a type of real manufacturing task, and/or a deviation from a planned manufacturing location.

8. The method according to one of the claims 1 to 7, wherein said filtering out comprises comparing the list of real manufacturing tasks assigned to each combination to the manufacturing tasks defined by said planned manufacturing operation in a sequence of manufacturing tasks, and discarding all combinations whose list does not include all the real manufacturing tasks defined by said planned manufacturing operation.

9. The method according to one of the claims 1 to 8, wherein said filtering out comprises determining whether a moving part of the fixed manufacturing asset defined according to the considered combination enters into collision with an object when performing said planned manufacturing operation at said planned manufacturing location and discarding all combinations for which a collision occurs.

10. The method according to one of the claims 1 to 8, wherein said filtering out comprises determining, for said combination, whether the fixed manufacturing asset defined according to said combination is able to reach said planned manufacturing location for performing said planned manufacturing operation, and discarding all combinations for which it is unreachable.

11. A computing system (100) comprising:
- a processor; and
- an accessible memory;
the computing system (100) being configured to carry out the method according to one of the claims 1 to 10.

12. A non-transitory computer-readable medium encoded with executable instructions that, when executed, cause one or more data processing system to perform the steps of the method according to one of the claims 1 to 10.

## Patentansprüche

1. Verfahren zum Bestimmen einer Position eines stationären Produktionsgegenstands (310, 320) in einer physischen Umgebung (300), wobei das Verfahren umfasst, dass ein Rechensystem (100) :
- eine virtuelle Darstellung der physischen Umgebung (300) empfängt (201), die mindestens einen planmäßigen Produktionsstandort umfasst, wobei der planmäßige Produktionsstandort so konfiguriert ist, dass er in der physischen Umgebung (300) eine Position definiert, an der an einem Produkt (330) ein planmäßiger Produktionsvorgang durchgeführt werden muss,
- eine virtuelle Darstellung einer oder mehrerer stationärer Produktionsanlagen (310, 320) empfängt (202), wobei jede stationäre Produktionsanlage eine feste Basis (313, 323) umfasst,
- für jede der stationären Produktionsanlagen einen Satz Grundpositionen empfängt oder bestimmt (203), die es der stationären Produktionsanlage ermöglichen, den planmäßigen Produktionsvorgang an dem Produkt (330) auszuführen,
- eine oder mehrere Regeln empfängt (204), wobei jede Regel für eine reale Produktionsaufgabe aus einem vorgegebenen Satz realer Produktionsaufgaben einen Bereich von Werten definiert, die beim Durchführen der realen Produktionsaufgabe zulässig sind,
- in Abhängigkeit von der für die betreffende reale Produktionsaufgabe definierten Regel für jede reale Produktionsaufgabe aus dem vorgegebenen Satz einen Satz künstliche Produktionsstandorte generiert (205),
- jeden künstlichen Produktionsstandort mit einer Punktzahl bewertet (206), wobei die Wahrscheinlichkeit, dass es sich bei dem künstlichen Produktionsstandort um einen zukünftigen realen Standort handelt, um so größer ist, je höher die Punktzahl ist,
- für jede der stationären Produktionsanlagen eine Liste Werkzeuge empfängt (207), wobei jedes Werkzeug für die stationäre Produktionsanlage ausgelegt und so konfiguriert ist, dass es dieser ermöglicht, eine oder mehrere der realen Produktionsaufgaben aus dem vorgegebenen Satz auszuführen,
- für jede stationäre Produktionsanlage sämtliche Kombinationen von Grundpositionen der stationären Produktionsanlage und Werkzeugen der stationären Produktionsanlage berechnet (208) und für jede Kombination die realen Produktionsaufgaben auflistet, die mit der betrachteten Kombination verrichtet werden können,
- für jede stationäre Produktionsanlage sämtliche berechneten Kombinationen herausfiltert (209), die den planmäßigen Produktionsvorgang nicht ausführen können,
- für jede verbleibende berechnete Kombination einen Satz erreichbarer künstlicher Produktionsstandorte ermittelt (210), der sämtliche künstlichen Produktionsstandorte aus jedem der Sätze künstlicher Produktionsstandorte umfasst, die für eine reale Produktionsaufgabe generiert wurden, welche in der Liste realer Produktionsaufgaben für die betrachtete Kombination aufgelistet sind und von dem stationären Produktionsgegenstand (310, 320) laut Definition gemäß der betreffenden Kombination erreicht werden können,
- für jede der verbleibenden berechneten Kombinationen die Punktzahlen für die künstlichen Produktionsstandorte, die in dem Satz erreichbarer künstlicher Produktionsstandorte enthalten sind, zusammenaddiert (211), um einen Endpunktstand für die betreffende verbleibende berechnete Kombination zu erhalten,
- unter den verbleibenden berechneten Kombinationen die auswählt (212), die durch den höchsten Endpunktstand gekennzeichnet ist,
- die feste Basis des stationären Produktionsgegenstands aus der ausgewählten Kombination an der bei der ausgewählten Kombination angegebenen Grundposition in der virtuellen Darstellung der physischen Umgebung positioniert (213).

2. Verfahren nach Anspruch 1, wobei es sich bei dem stationären Produktionsgegenstand um einen Industrieroboter handelt.

3. Verfahren nach Anspruch 1 oder 2, das das Benutzen einer Erreichbarkeitskarte zwecks Ermittelns umfasst, ob ein stationärer Produktionsgegenstand einen künstlichen Produktionsstandort erreichen kann.

4. Verfahren nach einem der Ansprüche 1 und 3, wobei es sich bei den Aufgaben um eine oder mehrere der folgenden handelt:
- Drehen,
- Verschieben aus einer ersten zu einer zweiten Position,
- Schweißen,
- Bohren,
- Greifen,
- Komprimieren,
- Lackieren,
- Betätigen,
- Heben.

5. Verfahren nach einem der Ansprüche 1 bis 4, wobei die Regeln eine Abweichung von einer gegebenen Position und/oder von einem Winkel und/oder von einer Länge und/oder eine gegebene Toleranz in Bezug auf einen zum Produzieren des Produkts benutzten eingegebenen physischen Produktionsparameter und/oder eine Fläche oder ein Volumen definieren, in der/dem ein reale Produktionsaufgabe zulässig ist.

6. Verfahren nach einem der Ansprüche 1 bis 5, wobei es sich bei der Punktzahl um eine Beurteilung einer technischen Machbarkeit des Durchführens der realen Produktionsaufgabe an dem künstlichen Produktionsstandort handelt, wobei die technische Machbarkeit um so höher ist, je höher die Punktzahl ist.

7. Verfahren nach einem der Ansprüche 1 bis 6, wobei die Punktzahl in Abhängigkeit von einem Satz Parameter berechnet wird, der Folgendes umfasst: eine Entfernung, die den planmäßigen Produktionsstandort von dem künstlichen Produktionsstandort trennt, und/oder eine Anzahl anderer planmäßiger Produktionsstandorte innerhalb eines den künstlichen Produktionsstandort umgebenden vorgegebenen Volumens und/oder eine Entfernung, die die anderen planmäßigen Produktionsstandorte von dem betrachteten künstlichen Produktionsstandort trennt, und/oder eine Wahrscheinlichkeit eines Zusammenstoßes mit einem anderen stationären oder mobilen Produktionsgegenstand, wenn die Aufgabe an dem künstlichen Produktionsstandort durchgeführt wird, und/oder eine Art realer Produktionsaufgabe und/oder eine Abweichung von einem planmäßigen Produktionsstandort.

8. Verfahren nach einem der Ansprüche 1 bis 7, wobei das Herausfiltern ein Vergleichen von der Liste jeder Kombination zugeordneten realen Produktionsaufgaben mit den durch den planmäßigen Produktionsvorgang definierten Produktionsaufgaben in einer Abfolge von Produktionsaufgaben und ein Verwerfen sämtlicher Kombinationen umfasst, deren Liste nicht sämtliche durch den planmäßigen Produktionsvorgang definierten realen Produktionsaufgaben enthält.

9. Verfahren nach einem der Ansprüche 1 bis 8, wobei das Herausfiltern ein Ermitteln, ob ein sich bewegender Teil des stationären Produktionsgegenstands, der der betrachteten Kombination entsprechend definiert ist, mit einem Objekt zusammenstößt, wenn er den planmäßigen Produktionsvorgang an dem planmäßigen Produktionsstandort durchführt, und ein Verwerfen sämtlicher Kombinationen umfasst, bei denen es zu einem Zusammenstoß kommt.

10. Verfahren nach einem der Ansprüche 1 bis 8, wobei das Herausfiltern für die Kombination ein Ermitteln, ob der stationäre Produktionsgegenstand, der der Kombination entsprechend definiert ist, in der Lage ist, den planmäßigen Produktionsstandort zum Durchführen des planmäßigen Produktionsvorgangs zu erreichen, und ein Verwerfen sämtlicher Kombinationen umfasst, bei denen er nicht erreichbar ist.

11. Rechensystem (100), das Folgendes umfasst:
- einen Prozessor und
- einen zugänglichen Arbeitsspeicher,
wobei das Rechensystem (100) so konfiguriert ist, dass es das Verfahren nach einem der Ansprüche 1 bis 10 ausführt.

12. Nichtflüchtiges, computerlesbares Medium, das mit ausführbaren Anweisungen codiert ist, die, wenn sie ausgeführt werden, ein oder mehrere Datenverarbeitungssysteme dazu veranlassen, die Schritte des Verfahrens nach einem der Ansprüche 1 bis 10 durchzuführen.

## Revendications

1. Procédé de détermination de la position d'un actif de fabrication fixe (310, 320) au sein d'un environnement physique (300), le procédé comprenant,
par un système informatique (100) :
- la réception (201) d'une représentation virtuelle dudit environnement physique (300), comprenant au moins un emplacement de fabrication planifié, ledit emplacement de fabrication planifié étant configuré pour définir une position, au sein dudit environnement physique (300), où une opération de fabrication planifiée doit être réalisée sur un produit (330) ;
- la réception (202) d'une représentation virtuelle d'un ou plusieurs actifs de fabrication fixes (310, 320), chaque actif de fabrication fixe comprenant une base stationnaire (313, 323) ;
- la réception ou la détermination (203), pour chacun desdits actifs de fabrication fixes, d'un ensemble de positions de base permettant audit actif de fabrication fixe d'effectuer ladite opération de fabrication planifiée sur ledit produit (330) ;
- la réception (204) d'une ou plusieurs règles, dans lequel chaque règle définit, pour une tâche de fabrication réelle d'un ensemble prédéfini de tâches de fabrication réelles, une plage de valeurs qui sont autorisées lors de la réalisation de ladite tâche de fabrication réelle ;
- pour chaque tâche de fabrication réelle dudit ensemble prédéfini, la génération (205) d'un ensemble d'emplacements de fabrication fictifs en fonction de la règle définie pour la tâche de fabrication réelle concernée ;
- l'attribution (206) d'un score à chaque emplacement de fabrication fictif, dans lequel plus le score est élevé, plus la probabilité que l'emplacement de fabrication fictif devienne un emplacement réaliste est grande ;
- la réception (207), pour chacun des actifs de fabrication fixes, d'une liste d'outils, dans lequel chaque outil est adapté audit actif de fabrication fixe et configuré pour permettre à ce dernier d'effectuer une ou plusieurs desdites tâches de fabrication réelles de l'ensemble prédéfini ;
- pour chaque actif de fabrication fixe, le calcul (208) de toutes les combinaisons de positions de base d'actifs de fabrication fixes et d'outils d'actifs de fabrication fixes, et le listage, pour chaque combinaison, des tâches de fabrication réelles qui peuvent être accomplies par la combinaison considérée ;
- pour chaque actif de fabrication fixe, le filtrage (209) de toutes les combinaisons calculées qui ne permettent pas d'effectuer l'opération de fabrication planifiée ;
- pour chaque combinaison calculée restante, la détermination (210) d'un ensemble d'emplacements de fabrication fictifs atteignables comprenant tous les emplacements de fabrication fictifs de chacun des ensembles d'emplacements de fabrication fictifs générés pour une tâche de fabrication réelle figurant dans la liste de tâches de fabrication réelles pour la combinaison considérée et qui peuvent être atteints par l'unité de fabrication fixe (310, 320) définie selon la combinaison concernée ;
- pour chacune desdites combinaisons calculées restantes, l'addition (211) des scores des emplacements de fabrication fictifs compris dans ledit ensemble d'emplacements de fabrication fictifs atteignables afin d'obtenir un score final pour la combinaison calculée restante concernée ;
- la sélection (212), parmi les combinaisons calculées restantes, de la combinaison **caractérisée par** le score final le plus élevé ;
- le positionnement (213), dans ladite représentation virtuelle de l'environnement physique, de la base stationnaire de l'actif de fabrication fixe de la combinaison sélectionnée à la position de base donnée dans ladite combinaison sélectionnée.

2. Procédé selon la revendication 1, dans lequel l'actif de fabrication fixe est un robot industriel.

3. Procédé selon la revendication 1 ou 2, comprenant l'utilisation d'une carte d'atteignabilité pour déterminer si un actif de fabrication fixe peut atteindre un emplacement de fabrication fictif.

4. Procédé selon l'une des revendications 1 ou 3, dans lequel lesdites tâches sont une ou plusieurs de ce qui suit :
- la rotation ;
- la translation d'une première position vers une seconde position ;
- le soudage ;
- le perçage ;
- la préhension ;
- la compression ;
- la peinture ;
- l'actionnement ;
- le levage.

5. Procédé selon l'une des revendications 1 à 4, dans lequel lesdites règles définissent un écart par rapport à une position donnée, et/ou un angle, et/ou une longueur, et/ou une tolérance donnée par rapport à un paramètre physique de fabrication d'entrée utilisé pour la fabrication du produit, et/ou une zone ou un volume dans laquelle/lequel une tâche de fabrication réelle est autorisée.

6. Procédé selon l'une des revendications 1 à 5, dans lequel ledit score est une évaluation de la faisabilité technique de la réalisation de ladite tâche de fabrication réelle audit emplacement de fabrication fictif, plus le score est élevé, plus ladite faisabilité technique est élevée.

7. Procédé selon l'une des revendications 1 à 6, dans lequel ledit score est calculé en fonction d'un ensemble de paramètres comprenant une distance séparant l'emplacement de fabrication planifié de l'emplacement de fabrication fictif, et/ou un nombre d'autres emplacements de fabrication planifiés dans un volume prédéfini entourant l'emplacement de fabrication fictif, et/ou une distance séparant lesdits autres emplacements de fabrication planifiés de l'emplacement de fabrication fictif considéré, et/ou une probabilité de collision avec un autre actif de fabrication fixe ou mobile lors de la réalisation de ladite tâche audit emplacement de fabrication fictif, et/ou un type de tâche de fabrication réelle, et/ou un écart par rapport à un emplacement de fabrication planifié.

8. Procédé selon l'une des revendications 1 à 7, dans lequel ledit filtrage comprend la comparaison de la liste de tâches de fabrication réelles affectées à chaque combinaison avec les tâches de fabrication définies par ladite opération de fabrication planifiée dans une séquence de tâches de fabrication, et l'élimination de toutes les combinaisons dont la liste ne comprend pas toutes les tâches de fabrication réelles définies par ladite opération de fabrication planifiée.

9. Procédé selon l'une des revendications 1 à 8, dans lequel le filtrage comprend la détermination consistant à savoir si une partie mobile de l'actif de fabrication fixe défini selon la combinaison considérée entre en collision avec un objet lors de la réalisation de ladite opération de fabrication planifiée audit emplacement de fabrication planifié, et l'élimination de toutes les combinaisons pour lesquelles une collision se produit.

10. Procédé selon l'une des revendications 1 à 8, dans lequel le filtrage comprend la détermination, pour ladite combinaison, consistant à savoir si l'actif de fabrication fixe défini selon ladite combinaison est en mesure d'atteindre ledit emplacement de fabrication planifié pour la réalisation de ladite opération de fabrication planifiée, et l'élimination de toutes les combinaisons pour lesquelles il est inatteignable.

11. Système informatique (100) comprenant :
- un processeur ; et
- une mémoire accessible ;
- le système informatique (100) étant configuré pour effectuer le procédé selon l'une des revendications 1 à 10.

12. Support non transitoire lisible par ordinateur, codé avec des instructions exécutables qui, lorsqu'elles sont exécutées, amènent un ou plusieurs systèmes de traitement de données à réaliser les étapes du procédé selon l'une des revendications 1 à 10.
